(19) Europäisches Patentamt European Patent Office Office européen des brevets

(11) **EP 4 624 972 A1**

(12) **EUROPEAN PATENT APPLICATION**

(43) Date of publication:
**01.10.2025 Bulletin 2025/40**

(51) International Patent Classification (IPC):
**G01R 33/56** *(2006.01)* **G01R 33/567** *(2006.01)*

(21) Application number: **24167495.1**

(52) Cooperative Patent Classification (CPC):
**G01R 33/567; G01R 33/5608**

(22) Date of filing: **28.03.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
• **Cauley, Stephen Farman**
**Winchester, 01890 (US)**
• **Clifford, Bryan**
**Belmont, 02478 (US)**
• **Nickel, Marcel Dominik**
**91074 Herzogenaurach (DE)**
• **Polak, Daniel**
**91052 Erlangen (DE)**
• **Splitthoff, Daniel Nicolas**
**91080 Uttenreuth (DE)**

(74) Representative: **Siemens Healthineers**
**Patent Attorneys**
**Postfach 22 16 34**
**80506 München (DE)**

(54) **METHOD FOR PROVIDING A FINAL MOTION CORRECTED IMAGE DATASET BASED ON MAGNETIC RESONANCE DATA, DATA PROCESSING SYSTEM, COMPUTER PROGRAM AND COMPUTER-READABLE MEDIUM**

(57) Computer-implemented method for providing a final motion corrected image dataset (1) based on magnetic resonance data (2) concerning an object and/or a person (3), in particular a patient, comprising the steps of
- receiving magnetic resonance data (2),
- determining a first motion corrected image dataset (4) by solving a first optimization problem (5), wherein the first optimization problem (4) depends on the magnetic resonance data (2) and on motion data (6), wherein the motion data (6) concerns a movement of the object and/or the person (3) during the acquisition of the magnetic resonance data (2),
- processing the first motion corrected image dataset (4) by an algorithm for image quality improvement (7) to provide a processed image dataset (8),
- determining a second motion corrected image dataset (9) by solving a second optimization problem (10) that depends on the magnetic resonance data (2), on the motion data (6) and on the processed image dataset (8), and
- either providing the second motion corrected image dataset (9) as the final motion corrected image dataset (1) or determining the provided final motion corrected image dataset (1) based on the second motion corrected image dataset (9).

FIG 2

EP 4 624 972 A1

**Description**

The invention concerns a computer-implemented method for providing a final motion corrected image dataset based on magnetic resonance data concerning an object and/or a person, in particular a patient. Additionally, the invention concerns a computer-implemented method for providing at least one trained machine learning model, a data processing system, a computer program and a computer-readable medium.

In an era of rising medical imaging utilization, e.g., for regular magnetic resonance screenings for Alzheimer's drug treatment, and increasing use of quantitative disease biomarkers and clinical support systems, e.g., of brain morphometry and hemorrhage, edema and tumor identification and/or segmentation, there is high demand for high-quality, fast, and reproducible magnetic resonance imaging techniques. Motion during the image data acquisition remains one of the largest sources of image quality degradation, especially in patients with neurodegenerative diseases. This can negatively affect the radiologist's image interpretation and/or diagnosis and/or affect the results of automated post-processing algorithms.

Deep learning image reconstruction has enabled reduced scan times while maintaining a high image quality and is now widely accepted in clinical settings. While faster scanning has been associated with a reduced likelihood of patient motion, it cannot solve the motion problem completely. A variety of retrospective motion correction techniques have been proposed:

The paper Cordero-Grande L, Hughes EJ, Hutter J, et al. Three-Dimensional Motion Corrected Sensitivity Encoding Reconstruction for Multi-Shot Multi-Slice MRI: Application to Neonatal Brain Imaging. Magnetic Resonance in Medicine 2018;79:1365-1376 (paper [1]), suggests using a combination of Sensitivity Encoding (SENSE) and a motion forward model (SENSE+motion). Estimating the motion trajectory and the motion-free image is achieved by minimizing the deviation between the physics model prediction and the acquired k-space data.

To avoid a computationally costly joint optimization, the Scout accelerated motion estimation and reduction (SAMER) technique used suggested in Polak D, Splitthoff DN, Clifford B, et al. Scout accelerated motion estimation and reduction (SAMER). Magn Reson Med. 2022;87:163-178. https://doi.org/10.1002/mrm.28971 (paper [2]), and Polak D, Hossbach J, Splitthoff DN, et al. Motion guidance lines for robust data consistency-based retrospective motion correction in 2D and 3D MRI. Magn Reson Med. 2023;1-14. doi: 10.1002/mrm.29534 (paper [3]). In this technique, additional k-space encoding lines, called motion guidance lines, and/or an ultra-fast scout scan are acquired and used as a prior to guide the motion search. This facilitates very rapid trajectory estimation in ~1 sec/shot. Once all motion parameters have been estimated, a SENSE+motion reconstruction is performed to obtain the motion mitigated image.

While the discussed approaches for retrospective motion compensation can provide a very good image quality at relatively low processing cost, when the k-space sampling is sufficiently dense, further accelerating the imaging sequence by, e.g., skipping a larger number of k-space points, can lead to a notable degradation of the image quality and of the reproducibility and robustness of the imaging.

The invention is therefore based on the problem of further improving the quality, robustness, and reproducibility of a retrospective motion compensation, in particular when an imaging sequence with highly undersampled data acquisition is used.

The problem is solved by a computer-implemented method for providing a final motion corrected image dataset based on magnetic resonance data concerning an object and/or a person, in particular a patient, comprising the steps of

- receiving magnetic resonance data,
- determining a first motion corrected image dataset by solving a first optimization problem, wherein the first optimization problem depends on the magnetic resonance data and on motion data, wherein the motion data concerns a movement of the object and/or the person during the acquisition of the magnetic resonance data,
- processing the first motion corrected image dataset by an algorithm for image quality improvement to provide a processed image dataset,
- determining a second motion corrected image dataset by solving a second optimization problem that depends on the magnetic resonance data, on the motion data and on the processed image dataset, and
- either providing the second motion corrected image dataset as the final motion corrected image dataset or determining the provided final motion corrected image dataset based on the second motion corrected image dataset.

It was found, that by using multiple motion correction steps with an intermediate application of an algorithm for image quality improvement, the quality, robustness, and reproducibility of a retrospective motion compensation can be noticeably improved. The algorithm for image quality improvement can, in particular, at least partially compensate the effects of high undersampling, e.g., of a sparse k-space sampling, e.g., noise amplification, residual aliasing artifacts, etc.

As will be discussed in more detail later, the algorithm for image quality improvement can in particular be a trained model that is based on machine learning. Such trained models are especially suited to compensate the effects of a sparse k-space sampling. It was found that a quite notable improvement of the image quality can be achieved, especially when multiple iterations of the motion compensation with an intermediate image quality improvement step are performed, as will be discussed in more detail below.

The inventive method allows for a retrospective motion correction and therefore for a motion correction that can be performed after the completion of the acquisition of the magnetic resonance data. The magnetic resonance data can especially be based on a parallel imaging technique that uses signals from multiple receiver coils to reduce imaging time. One of the more common parallel imaging techniques is the Sensitivity Encoding (SENSE) technique. This technique can be combined with a retrospective motion compensation, e.g., with the inventive method. Such a combination is often called "SENSE plus motion forward model" or "SENSE+motion".

The term "motion corrected image dataset" should be understood to refer to the output of an algorithm, that is designed to correct and/or compensate a motion of the object and/or the person, regardless of whether the input data of this algorithm actually concerns a moving object and/or person. The term does, e.g., refer to the respective result of the first and second optimization algorithm and to the result of the respective further optimization algorithm, that will be discussed later. The term "motion corrected image dataset" can therefore include cases, in which the input data of the respective algorithm is not actually affected by motion. The term "motion corrected image dataset" can therefore also be understood to mean "potentially motion corrected image dataset".

As discussed in the previously cited paper [1], the motion data can in principle be determined from magnetic resonance data that is provided by a typical imaging sequence, e.g., by a multi-shot, multi-slice spin echo sequence. As described in detail in this paper, this does however require to iteratively solve two partial optimization problems, namely the optimization of an approximate motion corrected image dataset based on previously determined approximate motion data and the optimization of the approximate motion data based on a previously determined approximate motion corrected image dataset.

Since such an alternating determination of motion data and a respective motion corrected image is highly computationally expensive, the previously cited papers [2] and [3] disclose a more computationally efficient approach called "Scout accelerated motion estimation and reduction" (SAMER). In these papers, the motion data is determined from specific parts of the magnetic resonance data, e.g., from a low-resolution scout scan and/or the motion guidance lines that are discussed in detail in these papers. The measurement sequence, on which the magnetic resonance data is based, can be designed in such a way, that the scout scan or the respective motion guidance lines for the respective shot are acquired in a sufficiently short time interval, that any motion of the object and/or the person during that time interval can be neglected.

Alternatively or additionally, any means for determining or tracking motion of an object or a person known from the prior art or invented in the future could be used to determine the motion data. Possible sources for the motion data are an optical tracking of markers attached to the object and/or the person, an evaluation of image data, especially of three-dimensional image data depicting the object and/or the person, motion sensors attached to the object and/or the person, the evaluation of the magnetic resonance data and/or other sensor data by a trained machine learning model etc. The motion data or sensor data on which the motion data is based can, e.g., be received with the magnetic resonance data. The determination of the motion data based on the magnetic resonance data or on specific parts of this magnetic resonance data, that was already discussed above, is however typically preferable, since no additional sensors, markers etc. are needed in this case.

The magnetic resonance data can be received directly from a magnetic resonance tomograph, read-out from a database, provided by a different routine or program running on the same device that implements the inventive method or received from different device, etc.

Optionally it is possible, to perform a further processing of the final motion corrected image dataset, e.g., to perform a noise reduction, a contrast modification and/or an edge enhancement. In particular the method can be used to process magnetic resonance data in the context of brain imaging, but also in the context of imaging other body parts.

The term "solving an optimization problem" is to be understood to include an approximate solution, e.g. a solution that is reached after a stopping condition is met in an iterative solver, e.g. after a given number of iterations were performed or once an approximate solution changes less than a threshold between iterations.

The determination of the final motion corrected image dataset based on the second motion corrected image dataset can comprise at least one iteration of the following group of steps:

- processing a respective input motion corrected image dataset by the algorithm for image quality improvement or by a respective further algorithm for image quality improvement for the respective iteration to provide a respective further processed image dataset for the respective iteration, wherein the second motion corrected image dataset is used as the input motion corrected image dataset in the first iteration and wherein a respective output motion corrected image dataset determined during the previous iteration is used as the respective input motion corrected image dataset for the respective iteration in all iterations after the first iteration, and
- determining a respective output motion corrected image dataset for the respective iteration by solving a respective further optimization problem that depends on the magnetic resonance data, on the motion data and on the respective further processed image dataset for the respective iteration,

wherein the output motion corrected image dataset determined in the last one of the iterations is provided as the final motion corrected image dataset.

Increasing the number of iterations will typically further improve the quality of the final motion corrected image dataset and/or, e.g., allow for an even sparser sampling of the k-space and therefore an even faster image acquisition while keeping the image quality approximately constant.

Preferably at least two or at least three iterations of the previously discussed group of steps and therefore at least three or at least four iterations of an image quality improvement followed by a motion compensation are used. A relatively low number of iterations, e.g., less than six or less than ten iterations of the group of steps, can in particular be sufficient, when SAMER or a different technique using a robust source of motion data is used. When the motion data is determined from normal magnetic resonance data without the use of the fast scout measurement or dedicated motion guidance lines, it can, e.g., be advantageous to use twenty or more iterations of the group of steps.

In particular when the same algorithm for image quality improvement is used in each iteration, multiple iterations could in principle be implemented as a loop, wherein each iteration of the loop uses the output of the previous iteration as its input. When the algorithm for image quality improvement is implemented as a trained machine learning model, as discussed in more detail below, it is however typically advantageous to use an end to the end training including all of the iterations that should be performed when using the model. When the iterations are implemented as a loop, this would however require the training of a recurrent model, e.g. of a recurrent neural network. Since a robust training of recurrent models can be more challenging than the training of, e.g., a pure feed forward network, the loop can be unrolled, leading to separate implementation of each iteration. Such an unrolling can especially be advantageous, when a relatively low number of iterations is used, which can, e.g., be sufficient, when the SAMER technique is used, as discussed above.

An unrolling of such a loop and therefore the separate implementation of each iteration of the group of steps also allows for an easy implementation of the use of different further algorithms for image quality improvement for each iteration or for at least some of the iterations. When the respective algorithm is implemented as a trained machine learning model, it is, e.g., possible, that the same basic algorithm is trained to implement the different algorithms for image quality improvement that are used in the different iterations. In this case the different further algorithms can use the same architecture of the machine learning model and just differ in their parametrization. It is however also possible, to use different architectures or even a different types of machine learning algorithms in different iterations. It would, e.g., be possible, to use a U-Net in the first couple of iterations and a transformer in the last iteration or in the last couple of iterations.

The second optimization problem can minimize a weighted sum of a first summand and a second summand by varying the second motion corrected image dataset, wherein the first summand is a measure for an inconsistency between the second motion corrected image dataset and the magnetic resonance data, wherein this measure is determined under the assumption that the motion data describes the movement of the object and/or the person during the acquisition of the magnetic resonance data, and wherein the second summand is a measure for an inconsistency between the second motion corrected image dataset and the processed image dataset.

During the minimization of this weighted sum, the second summand induces a similarity of the second motion corrected image dataset to the processed image dataset and can therefore, e.g., reduce noise and/or reduce the formation of artifacts that can result from an undersampling of the k-space in the magnetic resonance data. Since the first summand does enforce a high consistency of the second motion corrected image dataset with the magnetic resonance data and of the motion data, the optimization is designed to find solutions that are consistent with the actual measurement while at the same time minimizing issues due to an undersampling or other influences that negatively impact the image quality.

An exemplary formulation for the first summand will now be discussed for the case of a multi-shot acquisition, wherein the motion data describes a rigid-body motion of the object and/or the person with respect to the magnetic resonance device. Using a motion forward model, the relationship between the motion free image x and the multi-channel k-space data $s_i$ acquired for a given shot i can be given using an encoding operator $E_{\theta i}$ that depends on a motion path $\theta_i$ for the given shot i:

$$s_i = E_{\theta_i} x = M_i FCT_{\theta_i} R_{\theta_i} x,$$

In the example, $T_{\theta i}$ describes the translations and $R_{\theta i}$ the rotations given by the motion data for the given shot i. The operator C encodes the coil sensitivity maps and the operator F performs a Fourier transform. An undersampling mask $M_i$ can be used to describe the undersampling in the k-space.

The encoding operator $E_{\theta i}$ used in the example corresponds to the encoding operator used in the previously cited paper [2]. As, e.g., discussed in the previously cited papers, other formulations of the encoding operator can also be used, e.g., to formulate an encoding operator that include a spatial sampling mask. While the translations and rotations are performed in image space in the example, all or some of the transformations and/or rotations could also be performed in k-space or could be implemented as part of the Fourier-transformation by using a non-uniform Fourier-transform.

When each shot comprises motion guidance lines and/or when a low-resolution scout scan $\bar{x}$ can be considered to be approximately motion free, an actual motion path $\hat{\theta}_i$ for the respective shot i can be determined as follows:

$$\left[\hat{\theta}_i\right] = argmin_{\theta_i}\left\|E_{\theta_i}\tilde{x} - s_i\right\|_2^2$$

Using this actual motion path, the second optimization problem can then be written as:

$$\left[\hat{x}\right] = argmin_x\left\{\left\|E_{\hat{\theta}}x - s\right\|_2^2 + \lambda\left\|x - x_{proc}\right\|_2^2\right\}$$

In this equation $\hat{x}$ corresponds to the second motion corrected image dataset that is to be determined by this optimization problem, x is the image dataset that is varied to solve this optimization problem and $\mathbf{x_{proc}}$ is the processed image dataset. The weighting factor $\lambda$ scales the influence of the algorithm for image quality improvement on the resulting image dataset. This factor can be chosen depending on the concrete application, e.g., by a user or a developer of the image processing algorithm, or it can, e.g., be determined during a training process of the algorithm for image quality improvement. In general, the encoding operator can be the only part of the problem that explicitly depends on the motion data.

The first optimization problem can, in particular, minimize a measure for an inconsistency between the first motion corrected image dataset and the magnetic resonance data. The first optimization problem can therefore, e.g., correspond to a minimization of the first summand given above. It can however be advantageous, when the first optimization problem minimizes a weighted sum of this measure and a regularization term that depends on the first motion corrected image dataset. Such a regularization is suggested in the previously cited paper [2]. The regularization term could, e.g., be or comprise a measure for the noise in the first motion corrected image dataset.

The further optimization problem can minimize a weighted sum of a first summand and a second summand by varying the respective output motion corrected image dataset, wherein the first summand is a measure for an inconsistency between the respective output motion corrected image dataset and the magnetic resonance data, wherein this measure is determined under the assumption that the motion data describes the movement of the object and/or the person during the acquisition of the magnetic resonance data, and wherein the second summand is a measure for an inconsistency between the respective output motion corrected image dataset and the respective further processed image dataset.

The optimization approach that was previously discussed with respect to the second optimization problem can therefore, additionally or alternatively, be used to implement the further optimization problem. For this purpose, the further processed image dataset for the respective iteration replaces the processed image dataset in the equation given above and the result of the minimization is the respective output motion corrected image dataset for the respective iteration. While the same weighting factor $\lambda$ can, in principle, be used for each iteration and therefore for each one of the further optimization problems, it can be advantageous, to use different weighting factors **A** for the different iterations.

The measure for the inconsistency between the second motion corrected image dataset and the magnetic resonance data can be determined as a measure for the difference between an at least partial representation of the magnetic resonance data and artificial measurement data generated by an application of an encoding operator on the second motion corrected image dataset.

Additionally or alternatively, the measure for the inconsistency between the respective output motion corrected image dataset and the magnetic resonance data can be determined based on a difference between the at least partial representation of the magnetic resonance data and artificial measurement data generated by an application of the encoding operator on the respective output motion corrected image dataset.

As discussed above, this approach allows for a combination of an algorithm for image quality improvement with a motion correction based on a motion forward model implemented by the encoding operator. This can especially be used to implement a "SENSE plus motion forward model" approach. The respective encoding operator can depend on the motion data.

The at least a partial representation of the magnetic resonance data can, e.g., be a vector that comprises all measurements or at least the measurements that are not part of the scout measurement and/or the motion guidance lines that are used to determine the motion data.

The encoding operator can comprise a non-uniform Fourier-transform, wherein the non-uniform Fourier-transform is parametrized by the motion data. In the previous example for the encoding operator, it was assumed, that explicit image transformations, namely translations $\boldsymbol{T_{\theta i}}$ and rotations $\boldsymbol{R_{\theta i}}$ in image space, are used to transform the second motion corrected image dataset and the respective output motion corrected image dataset. Especially a rotation of an image dataset is however quite computationally expensive. Since such a rotation would need to be repeated during each iteration of the minimization, the computational requirements, in particular the time requirement, for the optimization can be noticeably reduced, when such an explicit rotation is avoided. It was found, that rotations and optionally also translations can be avoided in the previously discussed approach, when the uniform Fourier-transform is replaced by a non-uniform Fourier-transform. In this case, it is sufficient to adjust the sampling pattern that is used during the Fourier-transform instead of using a full translation and/or rotation of the image dataset. The replacement of the explicit rotations by a non-uniform Fourier-transform did speed up the optimization by up to an order of magnitude in experiments performed during the development of the invention.

The algorithm for image quality improvement and/or the respective further algorithm for image quality improvement can be or comprise a respective trained machine learning model. The further algorithm for image quality improvement and/or the respective further algorithm for image quality improvement can especially be designed to compensate for a relatively sparse and/or uneven sampling of the k-space during the acquisition of the magnetic resonance data.

Such a sparse and/or uneven sampling can decrease the time requirement for the acquisition of the magnetic resonance data and therefore reduce the influence of a motion of the object and/or the person on the image quality. On the other hand, such a sparse and/or uneven sampling of the k-space can however increase the noise floor and/or lead to the creation of certain image artifacts in the reconstructed image dataset. While it is in principle possible to alleviate some of these issues by manually designed algorithms, e.g., by using a lowpass filter to reduce noise, it was found, that trained machine learning models can be especially appropriate for such a task.

In general, a trained machine learning model mimics cognitive functions that humans associate with other human minds. In particular, by a training based on training data the machine learning model is able to adapt to new circum-stances and to detect and extrapolate patterns. Another term for "trained machine learning model" is "trained function".

In general, parameters of a machine learning model can be adapted by means of training. In particular, supervised training, semi-supervised training, unsupervised training, reinforcement learning and/or active learning can be used. Furthermore, representation learning (an alternative term is "feature learning") can be used. In particular, the parameters of machine learning models can be adapted iteratively by several steps of training. In particular, within the training a certain cost function can be minimized. In particular, within the training of a neural network the backpropagation algorithm can be used.

In particular, a machine learning model can comprise a neural network, a support vector machine, a decision tree and/or a Bayesian network, and/or the machine learning model can be based on k-means clustering, Q-learning, genetic algorithms and/or association rules. In particular, a neural network can be a deep neural network, a convolutional neural network, or a convolutional deep neural net-work. Furthermore, a neural network can be an adversarial network, a deep adversarial network and/or a generative adversarial network.

In a preferred embodiment, the algorithm for image quality improvement and/or at least one of the further algorithms for image quality improvement can be a convolutional neural network, e.g., having a U-Net structure. Additionally or alternatively, the algorithm for image quality improvement and/or at least one of the further algorithms for image quality improvement can be a Transformer, e.g., a SWIN-Transformer or a Reformer.

The actual training of the algorithm for image quality improvement and/or of the respective further algorithm for image quality improvement is preferably not part of the computer-implemented method according to the present invention. It can be performed in a preparatory step outside of the method itself., e.g., by the developer of a software product or a service that implements the computer-implemented method. Alternatively, it is however possible, to perform the training as an additional step of the discussed method.

The invention also concerns a computer-implemented method for providing at least one trained machine learning model, wherein the respective trained machine learning model is trained to implement the algorithm for image quality improvement and/or the respective further algorithm for image quality improvement in the computer-implemented method for providing a final motion corrected image dataset according to the present invention, the method comprising:

- receiving multiple training datasets, wherein each training dataset comprises input data for an overall machine learning model and, in particular, a reference image dataset that is related to the input data,
- training the overall machine learning model based on the multiple training datasets to determine the trained overall machine learning model, such that the trained overall machine learning model comprises on the one hand a trained first partial machine learning model and at least one trained further partial machine learning model and/or on the other hand multiple identical copies of the trained first partial machine learning model, and
- providing the trained first partial machine learning model as the algorithm for image quality improvement and/or providing the respective trained further partial machine learning model as the respective further algorithm for image quality improvement.

As discussed in more detail above, the computer-implemented method for providing a final motion corrected image dataset according to the present invention can in particular use an iterative approach, in which the output of the algorithm or the further algorithm for image quality improvement is reused as the input for the same algorithm or another one of the further algorithms for image quality improvement after an intermediate motion compensation step. By training the overall machine learning model, as discussed above, an end-to-end training of the overall algorithm can be achieved.

The respective reference image dataset can depict a healthy person, a patient and/or an inanimate object, e.g. a phantom.

When each training dataset comprises input data and a reference image dataset, a supervised training can easily be implemented, wherein the respective input data is used as an input for the overall machine learning model and the training is designed to minimize the difference between the output of the overall machine learning model for the respective input data and the reference image dataset taken from the same training dataset as the input data. Various approaches for implementing such a supervised training are well known in the art and will therefore not be discussed in detail. It is, e.g., possible to use a backpropagation of error, e.g., using a gradient descent approach, in particular using the Adam optimizer.

The use of multiple identical copies of the trained first partial machine learning model within the trained overall machine learning model can be useful, when the same algorithm for image quality improvement should be used in all or at least multiple iterations of the image quality improvement discussed above. This can be achieved by limiting the variation of the parameters, e.g. of the input weights of different neurons, of the overall machine learning model in such a way, that these parameters are identical for all copies. Such a limitation can be useful to limit the number of parameters that need to be determined during the training. Such a limitation can speed up the training and/or allow for a training with a lower number of training datasets.

It was however found, that it is typically advantageous to use mutually different algorithms for image quality improvement in at least some of the iterations and therefore to allow different parametrizations of the different partial machine learning models or to even use mutually different architectures for at least some of the partial machine learning models, especially when a sufficient amount of training data is available.

The input data and the reference image dataset for the respective training dataset can be based on the same k-space data, in particular on the same magnetic resonance data. The input data can, e.g., be generated by only selecting data for a subgroup of the k-space points of this k-space data, e.g., by only incorporating data for every second or third point in a respective spatial direction. This can especially be used to simulate an undersampling of the k-space, e.g., in an accelerated magnetic resonance imaging. The input data can directly correspond to this undersampled k-space data and therefore, e.g., be simulated magnetic resonance data for an accelerated magnetic resonance imaging. Alternatively, the input data can be reconstructed from this undersampled k-space data. The reference image dataset can be reconstructed from the full k-space data. The respective input data and reference image dataset can be generated on the fly or in a preparation step before the beginning of method.

The overall machine learning model can in particular be trained to provide an output based on undersampled k-space data or based on image data based thereon, that at least partially compensates an image degradation due to the undersampling.

When an algorithm for image quality improvement and/or a respective further algorithm for image quality improvement trained by the discussed method is used in the previously discussed computer-implemented method for providing a final motion corrected image dataset, features of the training implicitly determine features of the algorithm for image quality improvement and/or the respective further algorithm for image quality improvement, even when the actual training is performed outside of this method. Therefore, the discussed features of the training can limit the scope of the discussed computer-implemented method for providing a final motion corrected image dataset, even when the training itself is not part of that method. In general, features discussed with respect to the computer-implemented method for providing at least one trained machine learning model can be transferred to the computer-implemented method for providing a final motion corrected image dataset and vice-versa, to achieve the discussed advantages in the respective other method.

The trained overall machine learning model can be structured in such a way,

- that the respective trained further partial machine learning model processes provided data that is based on respective output data provided by either the trained first partial machine learning model or by a different one of the respective trained further partial machine learning models, and/or
- that all but one of the copies of the trained first partial machine learning model process provided data based on output data provided by another copy of the trained first partial machine learning model.

The respective input data can be based on or describe magnetic resonance data, wherein the trained overall machine learning model is structured in such a way, that the respective provided data is provided by solving a respective optimization problem that depends on the magnetic resonance data and the respective output data.

The respective optimization problem can correspond to the second optimization problem or the further optimization problem in the computer-implemented method for providing a final motion corrected image dataset according to the present invention, wherein the motion data that parametrizes the second optimization problem or the further optimization problem is set to indicate no movement of the object and/or the person during the acquisition of the magnetic resonance data.

In the simplest case, this can be achieved by using the full computer-implemented method for providing a final motion corrected image dataset as the overall machine learning model with the modification of using fixed movement data that indicates no movement. This can, e.g., be achieved in the example given above by setting the translations $T_{\theta i}$ and rotations $R_{\theta i}$ to unity. To reduce the computational load of the training, a modified encoding operator $E_\theta$ can however instead be used during the training, that is independent from the movement data and therefore, e.g., does not include $T_{\theta i}$ and/or $R_{\theta i}$. Additionally or alternatively, the modified encoding operator used during the training can use a uniform Fourier-transform that does not depend on the motion data instead of the non-uniform Fourier-transform discussed above.

In particular, the computer-implemented method for providing at least one trained machine learning model according to the present invention can therefore assume, that the respective input data is essentially motion free. Appropriate input data or reference data, on which such input data can be based, can, e.g., be manually or automatically selected from a pool of possible input data or it can be specifically recorded for this purpose.

A Training with essentially motion free training data can be sufficient, since the trained models are to be used in the previously discussed computer-implemented method for providing a final motion corrected image dataset only after a motion correction is performed. Therefore, it can be assumed, that only a relatively minor influence of motion remains in the data processed by the trained model.

Assuming an essentially motion free input can increase the speed of the training and can require less training data. In an alternative embodiment, it would however be possible, to, e.g., introduce artificial motion by a further modification of the reference data to generate the input data. It is, e.g., possible to use essentially motion free reference data, that can, e.g., represent magnetic resonance data from a multi-shot acquisition. The reference data can then be used to generate the reference image dataset. To generate the input data, patient motion between the shots can be simulated, which can be performed additionally or alternatively to the previously discussed discarding of some of the k-space points. When artificial movement is generated, appropriate motion data is already known and can be provided with the training dataset.

When the optimization problems are based on a weighted sum, e.g., one of the parameter λ as discussed above, the weights, e.g. the parameter λ, can be learned during the training or held at a fixed value.

Additionally, the invention concerns a data processing system that it is designed to carry out the computer-implemented method for providing a final motion corrected image dataset according to the present invention and/or the computer-implemented method for providing at least one trained machine learning model according to the present invention. The data processing system can, e.g., be a desktop computer or a server or it can be implemented as a cloud solution. Alternatively, it can be integrated into a medical imaging device. The data processing system can have hardware and/or software interfaces for receiving the various inputs and providing the outputs discussed above.

The invention also concerns a computer program that comprises instructions to carry out the computer-implemented method for providing a final motion corrected image dataset according to the present invention and/or the computer-implemented method for providing at least one trained machine learning model according to the present invention, when the program is executed on a data processing system.

Additionally the invention concerns a computer-readable medium comprising the computer program according to the present invention.

Independent of the grammatical term usage, individuals with male, female or other gender identities are included within the term.

Other objects and features of the present invention will become apparent from the following detailed description considered in conjunction with the accompanying drawings. The drawings, however, are only principal sketches designed solely for the purpose of illustration and do not limit the invention. The drawings show:

Fig. 1     a flowchart of an embodiment of the computer-implemented method for providing a final motion corrected image dataset according to the present invention,

Fig. 2     an embodiment of the data processing system according to the present invention in a use case for the method according to fig. 1,

Fig. 3     relevant functions and data structures for an exemplary implementation of the second and the further optimization problems in fig. 1,

Fig. 4     an exemplary embodiment of the computer-implemented method for providing at least one trained machine learning model according to the present invention, and

Fig. 5     a possible architecture for the algorithms for image quality improvement trained in fig. 4.

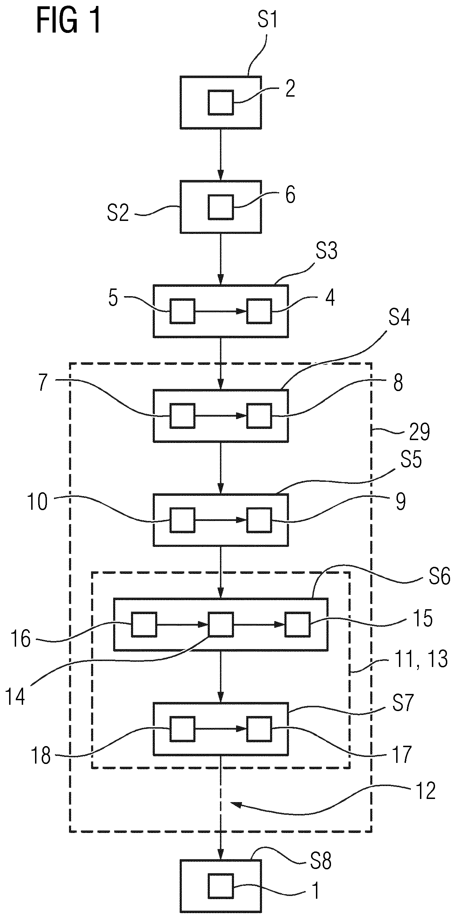

Fig 1 shows a flowchart of a computer-implemented method for providing a final motion corrected image dataset 1 based on magnetic resonance data 2 concerning a person 3, in particular a patient. Additionally or alternatively, the magnetic resonance data 2 can concern an object, as discussed in the general part of the description. In the example, the method is designed to improve the image quality of the final motion corrected image dataset 1 by, on the one hand, compensating for a movement of the person 3 and, on the other hand, compensating for a sparse k-space sampling during the image acquisition.

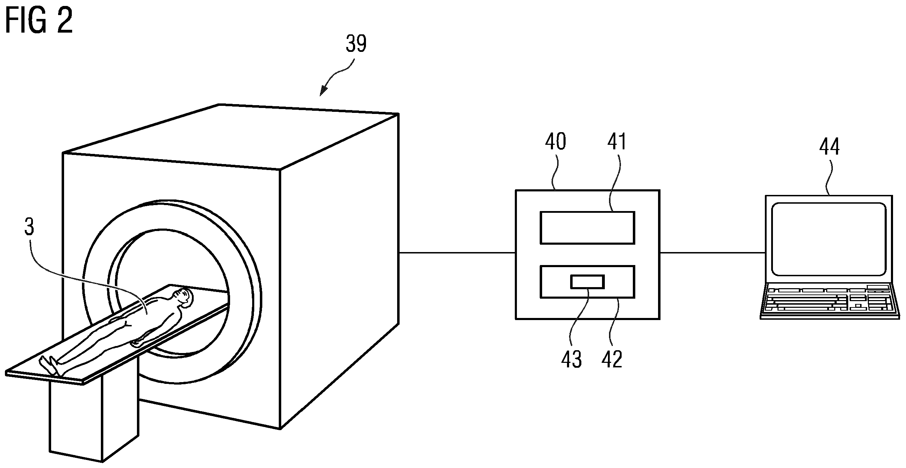

In the use case shown in fig. 2, the magnetic resonance data 2 is directly provided to the data processing system 40 by a magnetic resonance imaging device 39 in step S1. It would however also be possible, to process previously acquired magnetic resonance data 2 that is stored in a database or taken from a different source.

In the example shown in fig. 2, the data processing system 40 is implemented by a freely programmable data processing system 40, e.g., a server or a cloud solution. It would however also be possible, to integrate the data processing system 40 into the magnetic resonance imaging device 39 or to implement it within the workstation 44.

A computer program 43 implementing the steps of the method is stored in a memory 42 of the data processing system 2, that can also be understood to be a computer readable storage medium. The computer program is executed by the process of 41. In the example, the final motion corrected image dataset 1 is forwarded to the workstation 44 for visualization. It would however also be possible, to further process the final motion corrected image dataset 1, e.g., for an automatic feature recognition, and/or to store it in a storage device.

In the example, the measurement sequence used for acquiring the magnetic resonance data 2 is designed in such a way, that for each shot a small part of the acquired magnetic resonance data is acquired during a very short time interval and can therefore be assumed to be motion free. This part of the magnetic resonance data can in particular correspond to the motion guidance lines and/or a low-resolution scout scan $\tilde{x}$ that were discussed in the general part of the description.

In step S2, motion data 6 that concerns a movement of the person 3 during the acquisition of the magnetic resonance data 2 is determined. In the example the motion data 6 is determined based the motion guidance lines and/or a low-resolution scout scan $\tilde{x}$ by determining an actual motion path $\hat{\theta}_i$ for the respective shot i using the Formula

$$[\hat{\theta}_i] = argmin_{\theta_i} \left\| E_{\theta_i} \tilde{x} - s_i \right\|_2^2$$

as already discussed in detail in the general part of the description.

In step S3, a first motion corrected image dataset 4 is determined by solving a first optimization problem 5. The first optimization problem 5 depends on the magnetic resonance data 2 and on the motion data 6 and can, e.g., be formulated as:

$$[\hat{x}] = argmin_x \left\| E_{\hat{\theta}} x - s \right\|_2^2,$$

wherein $\hat{x}$ corresponds to the first motion corrected image dataset 4, **x** is the image dataset that is varied to solve this optimization problem and $\boldsymbol{E}_{\hat{\theta}}$ is the encoding operator that was already discussed in detail in the general part of the description in the context of the further optimization problem. As already discussed in the general part of the description, it would optionally be possible, to add a regularization term to the first optimization problem.

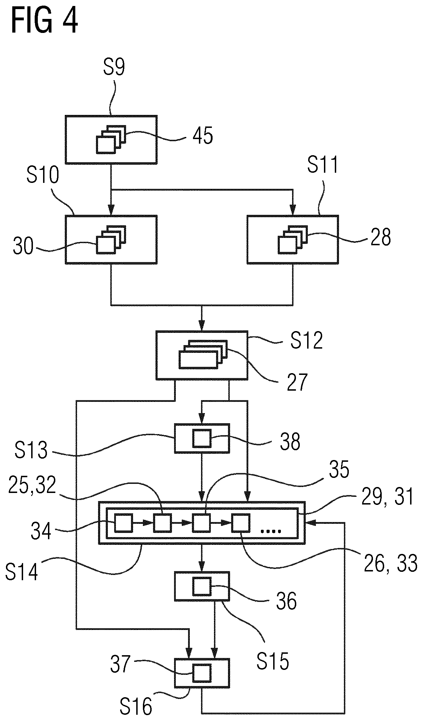

In step S4, the first motion corrected image dataset 4 is processed by an algorithm for image quality improvement 7 to provide a processed image dataset 8. As will be discussed in more detail with reference to fig. 4 later, the algorithm for image quality improvement 7 can in particular be trained by machine learning. As already discussed in the general part of the description, the algorithm for image quality improvement 7 is, in particular, designed and/or trained to compensate for the effects of the sparse k-space sampling.

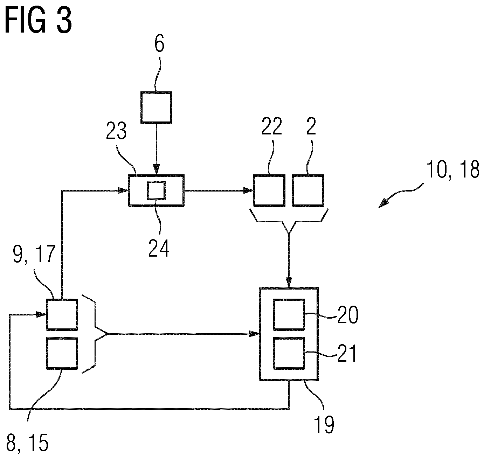

In step S5, a second motion corrected image dataset 9 is determined by solving a second optimization problem 10 that depends on the magnetic resonance data 2, on the motion data 6 and on the processed image dataset 8. A possible formulation of this optimization problem was already given in the general part of the description. For completeness's sake, a graphical representation of the structure of the second optimization problem 10 is given in fig. 3. It should be noted that the same structure can also be used to implement the further optimization problem 18 that will be discussed later.

As indicated in fig. 3, the second optimization problem 10, that is used in the example, minimizes a weighted sum 19 of a first summand 20 and a second summand 21 by varying the second motion corrected image dataset 9. The starting point for the variation can, e.g., be the first motion corrected image dataset 4 or the processed image dataset 8. The optimization can, e.g., be implemented using a gradient decent.

The first summand 20 is a measure for an inconsistency between the second motion corrected image dataset 9 and the magnetic resonance data 2. This measure is determined as a measure for the difference between an, in particular partial, representation of the magnetic resonance data 2 that can, in particular, excludes the low-resolution scout and/or the motion guidance lines used to determine the motion data 6, and artificial measurement data 22 generated by an application of an encoding operator 23 on the second motion corrected image dataset 9.

As already discussed in detail in the general part of the description, the encoding operator 23 depends on the determined motion data 6. In the example shown in fig. 2, the encoding operator 23 comprises a non-uniform Fourier-transform 24 that can be used to encode the motion data without requiring an explicit rotation and/or translation.

The second summand 21 is a measure for an inconsistency between the second motion corrected image dataset 9 and the processed image dataset 8.

The resulting second motion corrected image dataset 9 could, in principle, be provided as the final motion corrected image dataset 1. it was however found that it is typically advantageous, to perform multiple iterations of an image quality improvement, as implemented in step S4, followed by a respective motion corrected reconstruction, as implemented by step S5.

In the example shown in fig. 2, this is implemented by performing multiple iterations 11, 12 of a group 13 of steps comprising the steps S6 and S7. For simplicity's sake, fig. 1 only shows the first iteration 11 explicitly, indicating the further iterations 12 by a dashed line. While the multiple iterations 11, 12 could in principle be implemented by a loop, it is typically advantageous to unroll the loop, e.g., to allow for the use of different further algorithms for image quality improvement 14 in the different iterations.

In the respective step S6, a respective input motion corrected image dataset 16 is processed by a respective further algorithm for image quality improvement 14 to provide a respective further processed image dataset 15 for the respective iteration 11, 12. It should however be noted, that in other embodiments of the discussed method, it would also be possible, to use the previously discussed algorithm for image quality improvement 7 in at least some of the iterations 11, 12.

In the first iteration 11 of the group 13 of steps, the second motion corrected image dataset 9 is used as the input motion corrected image dataset 16. In the further iterations 12 a respective output motion corrected image dataset 17 that was determined during the previous iteration 11, 12 is used as the respective input motion corrected image dataset 16.

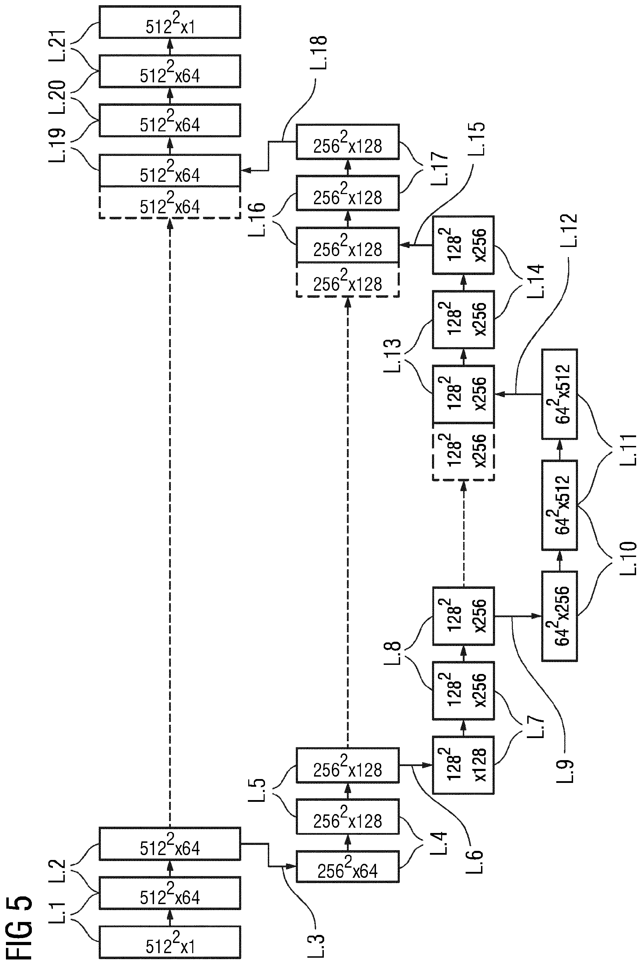

In the example, the respective algorithm for image quality improvement 7, 14 is implemented as a convolutional neural network, especially having a U-net structure, as shown in fig. 5. It would however also be possible to use a manual parametrized algorithm, e.g., the lowpass filter, to improve the image quality in steps S4 and/or S6.

In the respective step S7, a respective output motion corrected image dataset 17 for the respective iteration 11, 12 is determined by solving a respective further optimization problem 18 that depends on the magnetic resonance data 2, on the motion data 6 and on the respective further processed image dataset 15 for the respective iteration 11, 12. A possible implementation of the optimization was already discussed with reference to fig. 3 and the implementation of the second optimization problem 10. For implementing the further optimization problem 18, the respective output motion corrected image dataset 17 is used instead of the second motion corrected image dataset 9 and the respective further processed image dataset 15 is used instead of the processed image data set 8 in fig. 3.

Once a given number of iterations 11, 12 are completed, the output motion corrected image dataset 17 determined in the last one of the iterations 11, 12 is provided as the final motion corrected image dataset 1 in step S8.

Fig. 4 shows a flow chart of an exemplary computer-implemented method for providing a respective trained machine learning model 25, 26 for the algorithm for image quality improvement 7 and the respective further algorithm for image quality improvement 14.

The steps S9 to S11 form preparatory steps for providing multiple training datasets 27 to be used during the training. In a step S9, multiple sets of the reference data 45 are provided. The respective reference data 45 comprises magnetic resonance data that was acquired under a relatively dense k-space sampling on persons and/or objects, e.g. on phantoms, with a negligible influence of patient or object movement.

In step S10, the respective reference image dataset 30 is reconstructed for each set of reference data 45. Such a reconstruction can essentially correspond to the step S3 the fig. 1, except for the absence of motion correction.

In step S11, measurement data for at least some of the sampling positions in k-space, e.g., each second or of 2 out of 3 points in each one of the phase encoding directions, is discarded to provide a set of input data 28 for each one of the sets of reference and data 45. Step S11 can therefore be considered to emulate an accelerated magnetic resonance measurement providing a sparser k-space sampling than the magnetic resonance imaging used to provide the respective set of reference data 45.

In step S12, multiple training datasets 27 are provided by combining the respective set of input data 28 and the respective reference image dataset 30 that are based on the same set of reference data 45.

The following steps will perform an iterative training of an overall machine learning model 29 based on these training datasets 27. in a step S13, an initial reconstructed image 38 for the respective input data 28 is reconstructed. This reconstruction can essentially correspond to the step S3 in fig. 1, with the modification, that no motion of the person or object is assumed.

In the step S14, an overall machine learning model 29 is applied to the initial reconstructed image 38 to provide an output 36 of the overall machine learning model 29 in its current training state in step S15. During the first iteration of the training, the parameters of the overall machine learning model 29, e.g., input weights of various neurons, can, e.g., be initialized to zero.

The overall machine learning model 29 is setup in such a way, that, once the training is finished, the trained overall machine learning model 31 comprises a trained first partial machine learning model 32 and at least one trained further partial machine learning model 33. The trained first partial machine learning model 32 can then implement the algorithm for image quality improvement 7 and the respective trained further partial machine learning model 33 can implement the respective further algorithm for image quality improvement 14. Therefore, the trained first partial machine learning model 32 and the at least one trained further partial machine learning model 33 can be provided as the trained machine learning models 25, 26.

Such an overall machine learning model 29 can easily be implemented by using the steps S4 to S7 in fig. 1, including all of the iterations 11, 12, as the overall machine learning model 29. As already discussed in the general part of the description, the movement data 6 can be set to represent no movement or the overall machine learning model 29 can be slightly modified to, e.g., not comprise any operations that depend on the movement data 6.

By using such an overall model 29, the respective trained further partial machine learning model 33 will process provided data that is based on respective output data provided by either the trained first partial machine learning model 32 or by a different one of the respective trained further partial machine learning models 33. The respective provided data is provided by solving a respective optimization problem 34, 35. The optimization problems 34, 35 will correspond to the first and second optimization problem 10, 18 with the movement set to zero in this structure.

In step is S16 the cost function 37 is evaluated by comparing the output to 36 with the reference image dataset 30 for the respective training dataset 27. The cost function 37 is then minimized by iteratively varying the parameters of the overall machine learning model 29. in the example the Adam optimizer is used to adjust the parameters based on the cost function.

As already discussed in the general part of the description, the same approach for training can also be used, when multiple copies of the first partial machine learning model are used.

The respective trained machine learning model 25, 26 can, in particular, be a convolutional neural network that can, in particular, have a U-net structure. An exemplary structure of such a machine learning model is shown in fig. 5. For simplicity's sake, the processing of two-dimensional image data sets is assumed. This structure can, however, obviously be extended to process three-dimensional image data sets or even higher dimensional image data sets.

The input data to the machine learning network is a two-dimensional medical image comprising 512x512 pixel, every pixel comprising one intensity value. The machine learning network comprises convolutional layers (indicated by solid, horizontal arrows), pooling layers (indicating by solid arrows pointing down), and upsampling layers (indicated by solid arrows pointing up), the number of the respective nodes is indicated within the boxes. Within the U-net structure first the input images are downsampled (decreasing the size of the images and increasing the number of channels), afterwards they are upsampled (increasing the size of the images and decreasing the number of channels) to generate a transformed image.

All except the last convolutional layers L.1, L.2, L.4, L.5, L.7, L.8, L.10, L.11, L.13, L.14, L.16, L.17, L.19, L.20 use 3x3 kernels with a padding of 1, the ReLU activation function, and a number of filters / convolutional kernels that matches the number of channels of the respective node layers as indicated in fig. 5. The last convolutional layer L.22 uses a 1x1 kernel with no padding and the ReLU activation function.

The pooling layers L.3, L.6, L.9 are max-pooling layers, replacing four neighboring nodes with only one node, the value being the maximum of the values of the four neighboring nodes. The upsampling layers L.12, L.15, L.18 are transposed convolution layers with 3x3 kernels and stride 2, which effectively quadruple the number of nodes. The dashed horizontal errors correspond to concatenation operations, where the output of a convolutional layer L.2, L.5, L.8 of the downsampling branch of the U-net structure is used as additional inputs for a convolutional layer L.13, L.16, L.19 of the upsampling branch of the U-net structure. This additional input data is treated as additional channels in the input node layer for the convolutional layer L.13, L.16, L.19 of the upsampling branch.

**Claims**

1. Computer-implemented method for providing a final motion corrected image dataset (1) based on magnetic resonance data (2) concerning an object and/or a person (3), in particular a patient, comprising the steps of

    - receiving magnetic resonance data (2),
    - determining a first motion corrected image dataset (4) by solving a first optimization problem (5), wherein the first optimization problem (4) depends on the magnetic resonance data (2) and on motion data (6), wherein the motion data (6) concerns a movement of the object and/or the person (3) during the acquisition of the magnetic resonance data (2),
    - processing the first motion corrected image dataset (4) by an algorithm for image quality improvement (7) to provide a processed image dataset (8),
    - determining a second motion corrected image dataset (9) by solving a second optimization problem (10) that depends on the magnetic resonance data (2), on the motion data (6) and on the processed image dataset (8), and

- either providing the second motion corrected image dataset (9) as the final motion corrected image dataset (1) or determining the provided final motion corrected image dataset (1) based on the second motion corrected image dataset (9).

2. Computer-implemented method according to claim 1, **characterized in that** the determination of the final motion corrected image dataset (1) based on the second motion corrected image dataset (9) comprises at least one iteration (11, 12) of the following group (13) of steps:

- processing a respective input motion corrected image dataset (16) by the algorithm for image quality improvement (7) or by a respective further algorithm for image quality improvement (14) for the respective iteration (11, 12) to provide a respective further processed image dataset (15) for the respective iteration (11, 12), wherein the second motion corrected image dataset (9) is used as the input motion corrected image dataset (16) in the first iteration (11) and wherein a respective output motion corrected image dataset (17) determined during the previous iteration (11) is used as the respective input motion corrected image dataset (16) for the respective iteration (12) in all iterations (12) after the first iteration (11), and
- determining a respective output motion corrected image dataset (17) for the respective iteration (11, 12) by solving a respective further optimization problem (18) that depends on the magnetic resonance data (2), on the motion data (6) and on the respective further processed image dataset (15) for the respective iteration (11, 12), wherein the output motion corrected image dataset (17) determined in the last one of the iterations (11, 12) is provided as the final motion corrected image dataset (1).

3. Computer-implemented method according to one of the preceding claims, **characterized in that** the second optimization problem (10) minimizes a weighted sum (19) of a first summand (20) and a second summand (21) by varying the second motion corrected image dataset (9), wherein the first summand (20) is a measure for an inconsistency between the second motion corrected image dataset (9) and the magnetic resonance data (2), wherein this measure is determined under the assumption that the motion data (6) describes the movement of the object and/or the person (3) during the acquisition of the magnetic resonance data (2), and wherein the second summand (21) is a measure for an inconsistency between the second motion corrected image dataset (9) and the processed image dataset (8).

4. Computer-implemented method according to claim 2 or according to claim 3 and claim 2, **characterized in that** the further optimization problem (18) minimizes a weighted sum (19) of a first summand (20) and a second summand (21) by varying the respective output motion corrected image dataset (17), wherein the first summand (20) is a measure for an inconsistency between the respective output motion corrected image dataset (17) and the magnetic resonance data (2), wherein this measure is determined under the assumption that the motion data (6) describes the movement of the object and/or the person (3) during the acquisition of the magnetic resonance data (2), and wherein the second summand (21) is a measure for an inconsistency between the respective output motion corrected image dataset (17) and the respective further processed image dataset (15).

5. Computer-implemented method according to claim 3 or 4, **characterized**

- **in that** the measure for the inconsistency between the second motion corrected image dataset (9) and the magnetic resonance data (2) is determined as a measure for the difference between an at least partial representation of the magnetic resonance data (2) and artificial measurement data (22) generated by an application of an encoding operator (23) on the second motion corrected image dataset (9), and/or
- **in that** the measure for the inconsistency between the respective output motion corrected image dataset (17) and the magnetic resonance data (2) is determined based on a difference between the at least partial representation of the magnetic resonance data (2) and artificial measurement data (22) generated by an application of the encoding operator (23) on the respective output motion corrected image dataset (17).

6. Computer-implemented method according to claim 5, **characterized in that** the encoding operator comprises a non-uniform Fourier-transform (24), wherein the non-uniform Fourier-transform (24) is parametrized by the motion data (6).

7. Computer-implemented method according to one of the preceding claims, **characterized in that** the algorithm for image quality improvement (7) and/or the respective further algorithm for image quality improvement (14) is or comprises a respective trained machine learning model (25, 26).

8. Computer-implemented method for providing at least one trained machine learning model (25, 26), wherein the respective trained machine learning model (25, 26) is trained to implement the algorithm for image quality improvement (7) and/or the respective further algorithm for image quality improvement (14) in the computer-implemented method according to one of the preceding claims, the method comprising:

   - receiving multiple training datasets (27), wherein each training dataset comprises input data (28) for an overall machine learning model (29),
   - training the overall machine learning model (29) based on the multiple training datasets to determine the trained overall machine learning model (31), such that the trained overall machine learning model (31) comprises on the one hand a trained first partial machine learning model (32) and at least one trained further partial machine learning model (33) and/or on the other hand multiple identical copies of the trained first partial machine learning model (31),
   - providing the trained first partial machine learning model (32) as the algorithm for image quality improvement (7) and/or providing the respective trained further partial machine learning model (33) as the respective further algorithm for image quality improvement (14).

9. Computer-implemented method according to claim 8, **characterized in that** the trained overall machine learning model (31) is structured in such a way,

   - that the respective trained further partial machine learning model (33) processes provided data that is based on respective output data provided by either the trained first partial machine learning model (32) or by a different one of the respective trained further partial machine learning models (33), and/or
   - that all but one of the copies of the trained first partial machine learning model (32) process provided data based on output data provided by another copy of the trained first partial machine learning model (32).

10. Computer-implemented method according to claim 9, **characterized in that** the respective input data (28) is based on or describes magnetic resonance data, wherein the trained overall machine learning model (31) is structured in such a way, that the respective provided data is provided by solving a respective optimization problem (34, 35) that depends on the magnetic resonance data and the respective output data.

11. Computer-implemented method according to claim 10, **characterized in that** the respective optimization problem (34, 35) corresponds to the second optimization problem (10) or the further optimization problem (18) in the computer-implemented method according to one of the claims 1 to 8, wherein the motion data (6) that parametrizes the second optimization problem (10) or the further optimization problem (18) is set to indicate no movement of the object and/or the person (3) during the acquisition of the magnetic resonance data.

12. Data processing system, **characterized in that** it is designed to carry out the computer-implemented method according to one of the preceding claims.

13. Computer program, **characterized in that** it comprises instructions to carry out the computer-implemented method according to one of the claims 1 to 11 when the program is executed on a data processing system 40.

14. Computer-readable medium comprising the computer program 43 according to claim 13.

FIG 1

FIG 2

FIG 3

FIG 4

# FIG 5

| Label | Block |
|---|---|
| L.1 | $512^2$x1 |
| L.2 | $512^2$x64 |
| | $512^2$x64 |

| Label | Block |
|---|---|
| L.3 | $256^2$x64 |
| L.4 | $256^2$x128 |
| L.5 | $256^2$x128 |

| Label | Block |
|---|---|
| L.6 | $128^2$x128 |
| L.7 | $128^2$x256 |
| L.8 | $128^2$x256 |

| Label | Block |
|---|---|
| L.9 | $64^2$x256 |
| L.10 | $64^2$x512 |
| L.11 | $64^2$x512 |

| Label | Block |
|---|---|
| L.12 | $128^2$x256 |
| L.13 | $128^2$x256 |
| L.14 | $128^2$x256 |
| L.15 | $128^2$x256 |

| Label | Block |
|---|---|
| L.16 | $256^2$x128 |
| | $256^2$x128 |
| L.17 | $256^2$x128 |
| L.18 | $256^2$x128 |

| Label | Block |
|---|---|
| L.19 | $512^2$x64 |
| L.20 | $512^2$x64 |
| L.21 | $512^2$x64 |
| | $512^2$x64 |
| | $512^2$x1 |

18

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

**Application Number**

EP 24 16 7495

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAIKUN QI ET AL: "End-to-end deep learning nonrigid motion-corrected reconstruction for highly accelerated free-breathing coronary MRA", MAGNETIC RESONANCE IN MEDICINE, WILEY-LISS, US, vol. 86, no. 4, 6 June 2021 (2021-06-06), pages 1983-1996, XP071675394, ISSN: 0740-3194, DOI: 10.1002/MRM.28851 * page 1985 - page 1989; figures 1, 2 * | 1-7, 12-14 | INV. G01R33/56 G01R33/567 |
| X | LINGALA SAJAN GOUD ET AL: "Deformation Corrected Compressed Sensing (DC-CS): A Novel Framework for Accelerated Dynamic MRI", IEEE TRANSACTIONS ON MEDICAL IMAGING, IEEE, USA, vol. 34, no. 1, 1 January 2015 (2015-01-01), pages 72-85, XP011568786, ISSN: 0278-0062, DOI: 10.1109/TMI.2014.2343953 [retrieved on 2014-12-24] * page 75 - page 77 * | 1-6, 12-14 | |

TECHNICAL FIELDS
SEARCHED      (IPC)

G01R

-/--

### INCOMPLETE SEARCH

The Search Division considers that the present application, or one or more of its claims, does/do
not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 5 November 2024 | Raguin, Guy |

EPO FORM 1503 03.82 (P04E07)

page 1 of 2

Europäisches
Patentamt

European
Patent Office

Office européen
des brevets

## PARTIAL EUROPEAN SEARCH REPORT

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| A | CEMRE ARIYUREK ET AL: "Motion-compensated image reconstruction for improved kidney function assessment using dynamic contrast-enhanced MRI", NMR IN BIOMEDICINE, WILEY, LONDON, GB, vol. 37, no. 6, 15 February 2024 (2024-02-15), page n/a, XP072631743, ISSN: 0952-3480, DOI: 10.1002/NBM.5116 * page 3 * ----- | 6 | |
| | | | **TECHNICAL FIELDS SEARCHED** (IPC) |

EPO FORM 1503 03.82 (P04C10)

Europäisches
Patentamt

European
Patent Office

Office européen
des brevets

**INCOMPLETE SEARCH**
**SHEET C**

Application Number

EP 24 16 7495

Claim(s) completely searchable:
1-7

Claim(s) searched incompletely:
12-14

Claim(s) not searched:
8-11

Reason for the limitation of the search:

Pursuant to Rule 62a(1) EPC, the applicant was invited to select which independent claims to search amongst the two independent method claims (claims 1 and 8).

In their letter of reply dated 31-10-2024, the applicant argues that claims 1 and 8 define a plurality of interrelated products according to Rule 43(2)(a) EPC, noting that "For the purpose of Rule 43(2)(a), the term "interrelated" is interpreted to mean "different objects that complement each other or work together" (GL F-IV 3.2)" and that "the computer-implemented method for providing at least one trained machine learning model according to claim 8 "works together" with the computer-implemented method for providing a final motion corrected image dataset according to the preceding claims".

However, by definition, "A and B are interrelated" means A and B are related to one another, i.e. A is related to B and B is related to A. Therefore, the applicant merely demonstrated one half (namely, that claim 8 refers to claim 1) of what would be required in order to prove that the term "interrelated" applies to the methods of claims 1 and 8. And therein lies the problem: the method of claim 1 is not defined as being related to - or complement or work with (to use the wording of GL F-IV 3.2 as cited by the applicant) - that of claim 8 in any manner. Therefore, the methods of claims 1 and 8 are not interrelated in the meaning of Rule 43(2)(a) EPC and GL F-IV 3.2.

Consequently, pursuant to Rule 62a(1) EPC, the search is carried out on the basis of the first method (claim 1), and claims 8-11 are excluded from the search while the search of claims 12-14 is limited to when claims 12 and 13 refer back to claims 1-7 only.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CORDERO-GRANDE L** ; **HUGHES EJ** ; **HUTTER J et al.** Three-Dimensional Motion Corrected Sensitivity Encoding Reconstruction for Multi-Shot Multi-Slice MRI: Application to Neonatal Brain Imaging. *Magnetic Resonance in Medicine*, 2018, vol. 79, 1365-1376

- **POLAK D** ; **SPLITTHOFF DN** ; **CLIFFORD B et al.** Scout accelerated motion estimation and reduction (SAMER). *Magn Reson Med.*, 2022, vol. 87, 163-178, https://doi.org/10.1002/mrm.28971
- **POLAK D** ; **HOSSBACH J** ; **SPLITTHOFF DN et al.** Motion guidance lines for robust data consistency-based retrospective motion correction in 2D and 3D MRI. *Magn Reson Med.*, 2023, 1-14